# EUROPEAN PATENT SPECIFICATION

(11) **EP 2 423 512 B1**
(45) Date of publication and mention of the grant of the patent: **12.04.2017**
(21) Application number: 10174262.5
(22) Date of filing: 27.08.2010
(51) Int. Cl.: F04D 25/06, F04D 29/60, H05K 7/20

(54) **Fan module**
Lüftereinheit
Module de ventilateur

(43) Date of publication of application: 29.02.2012
(73) Proprietor: Giga-Byte Technology Co., Ltd., New Taipei City 231 (TW)
(72) Inventor: Lu, Tung-Ke, 231 Hsin-tien; (TW)
(74) Representative: Becker Kurig Straus

(56) References cited:
- US-A1- 2003 053 908
- US-A1- 2006 062 670
- US-A1- 2008 014 093
- US-A1- 2010 128 457
- US-B1- 6 611 427

## Description

### BACKGROUND OF THE INVENTION

### Field of the Invention

The invention relates to a fan module, and more particularly, to a fan module with ease of assembly.

### Description of Related Art

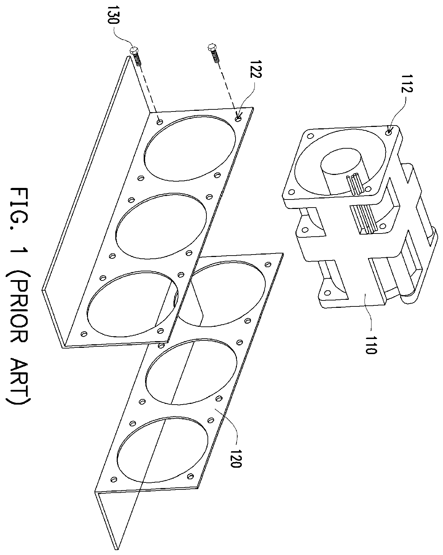

FIG. 1 is a schematic exploded view of a conventional fan module. With reference to FIG. 1, according to the related art, a fan 110 and a holder 120 are assembled by using a plurality of screws 130 that directly pass through fixing holes 122 of the holder 122, and the screws 130 are secured into fixing holes 112 located at four corners of the fan 110. However, manual use of the screws 130 requires labor time and costs of the screws 130.

An alternative fan module mounting system is known form US 6 611 427 B1.

### SUMMARY OF THE INVENTION

The invention is directed to a fan module with ease of assembly.

The invention provides a fan module including two brackets, a holder, and a fan. Each of the brackets has a first assembling portion. The holder has a U-shape body and an opening, and two of the second assembling portions are respectively disposed at two sides of the U-shape body. The fan is placed into the U-shape body through the opening. The holder is disposed between the brackets, and the first assembling portions of the brackets are assembled to the corresponding second assembling portions of the U-shape body.

According to an embodiment of the invention, the U-shaped body has two latching portions and a connecting portion connected between the two latching portions. The opening is located between the latching portions. When the fan is placed into the U-shaped body of the holder, the connecting portion is bent, such that the latching portions are relatively away from each other to increase a diameter of the opening. Besides, the latching portions and the connecting portion are in a plate-like shape, and the connecting portion are further formed a plurality of hollow portions. The latching portions of the U-shaped body have a plurality of first latching units. The fan has a plurality of second latching units corresponding to the first latching units. When the fan is placed into the U-shaped body of the holder, the first latching units correspondingly latch the second latching units. The first latching units may be protruding points or bumps, and the second latching units may be recesses or openings.

According to an embodiment of the invention, the first assembling portions are slots, and the second assembling portions are protruding shafts.

Based on the above, the U-shaped body of the holder in the fan module of the invention is resilient, and therefore an assembler can bend the U-shaped body to make the two latching portions relatively away from each other, and thus the fan can be easily assembled into the U-shaped body. The fan is then fixed to the body by means of the latching units. Thereafter, the first assembling portions and the second assembling portions are combined to complete the assembly of the fan module. Since no screw is required for assembling the fan module of the invention, labor costs and material costs can be effectively reduced according to the invention in comparison with the related art.

In order to make the aforementioned and other features and advantages of the invention more comprehensible, embodiments accompanying figures are described in detail below.

### BRIEF DESCRIPTION OF THE DRAWINGS

FIG. 1 is a schematic exploded view of a conventional fan module.
FIG. 2 is a schematic exploded view of a fan module according to an embodiment of the invention.
FIG. 3 is a schematic view of assembling the fan module depicted in FIG. 2.

### DESCRIPTION OF EMBODIMENTS

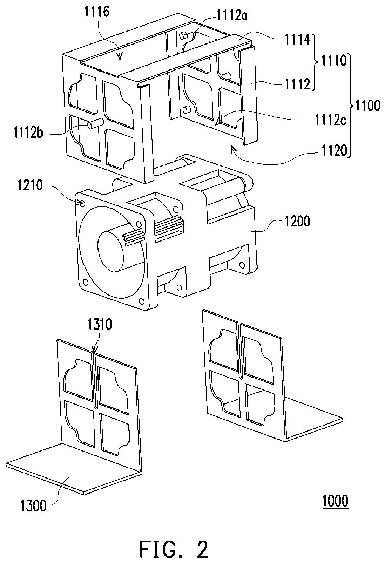

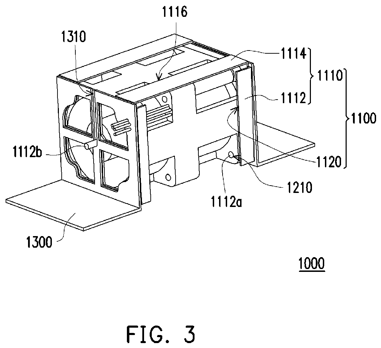

FIG. 2 is a schematic exploded view of a fan module according to an embodiment of the invention. FIG. 3 is a schematic view of assembling the fan module depicted in FIG. 2. With reference to FIG. 2 and FIG. 3, a fan module 1000 includes a holder 1100, a fan 1200, and two brackets 1300. The holder 1100 is disposed between the brackets 1300, and the holder 1100 has a U-shaped body 1110 and an opening 1120. When the fan 1200 and the holder 1100 are assembled together, the fan 1200 is placed into the U-shaped body 1100 through the opening 1120.

The U-shaped body 1110 of the holder 1100 has two latching portions 1112 and a connecting portion 1114 connected between the two latching portions 1112, and the opening 1120 is located between two of the latching portions 1112. Here, the latching portions 1112 and the connecting portion 1114 can be in a plate-like shape.

Additionally, the latching portions 1112 of the U-shaped body 1110 may have a plurality of first latching units 1112a located on inner surfaces 1112c of the latching portions 1112. The fan 1200 has a plurality of second latching units 1210 corresponding to the first latching units 1112a. The first latching units 1112a are protruding points, and the second latching units 1210 are openings. Based on actual demands, people having ordinary skill in the art are able to change the material of the U-shaped body 1110 and the shape of the first and second latching units 1112a and 1210. For instance, the U-shaped body 1110 can be made of plastic or metal. In addition, the first latching units 1112a can be bumps, and the second latching units 1210 can be recesses. Certainly, the first latching units 1112a can be openings or recesses formed by punching the latching portions 1112 which are metal plates, and the second latching units 1210 can be protruding points or bumps formed by injection molding.

When the fan 1200 is placed into the U-shaped body 1110 of the holder 1100, the two latching portions 1112 can be pulled open by an assembler, and free ends of the two latching portions 1112 are relatively away from each other due to the resilient force of the U-shaped body 1110. Thereby, the diameter of the opening 1120 is increased, such that it is easy for the assembler to place the fan 1200 into the U-shaped body 1110 through the opening 1120.

After the fan 1200 is placed into the U-shaped body 1110 of the holder 1100, the assembler can stop applying forces to the two latching portions 1112. Instead, the resilience of the U-shaped body 1110 allows the free ends of the two latching portions 1112 to return to the original position. Here, the first latching units 1112a of the latching portions 1112 correspondingly latch the second latching units 1210 of the fan 1200, and thereby the fan 1200 is fixed to the brackets 1100.

As indicated above, the fan 1200 can be easily placed into the holder 1100 after the two latching portions 1112 of the U-shaped body 1100 are pulled open by the assembler and away from each other. Besides, each of the brackets 1300 has a first assembling portion 1310, and a second assembling portion 1112b is disposed on each of the latching portions 1112 of the U-shaped body 1110. The first assembling portions 1310 are slots formed on the edge of the brackets 1300, for instance, and the second assembling portions 1112b are protruding shafts. When the assembly of the fan 1200 and the holder 1100 is assembled to the brackets 1300, the second assembly structures (protruding shafts) 1112b of the latching portions 1112 of the U-shaped body 1110 are placed into the first assembling portions (slots) 1310, therefore the assembling steps are easy and simple. It can be deduced from the above that the assembly of the fan module 1000 does not require screws according to the present invention. From the assembler's point of view, the fan module 1000 of the present invention can be easily assembled in comparison with the conventional fan module that requires the assembler to assemble the holder and the fan together by passing the screws through the holder and the fan with use of a screwdriver. Moreover, since no screw is required in the assembly process, costs can be reduced as well.

On the other hand, the connecting portion 1114 of the U-shaped body 1110 can be formed a plurality of hollow portions 1116 thereon for reducing the entire weight.

In light of the foregoing, since screws are not required for assembling the fan module of the invention, material costs of the screws are avoided. Furthermore, resilience of the holder allows the assembler to assemble the fan and the holder together in an easy and simple manner.

Although the invention has been described with reference to the above embodiments, it will be apparent to one of the ordinary skill in the art that modifications to the described embodiment may be made without departing from the scope of the invention as defined by the attached claims.

## Claims

1. A fan module (1000), **characterized by** comprising:
two brackets (1300), each of the brackets (1300) comprising a first assembling portion (1310) which is a slot formed on an edge of the bracket (1300);
a holder (1100) comprising a U-shaped body (1110) having two latching portions (1112) and a connecting portion (1114) connected between the latching portions (1112) and an opening (1120) located between the latching portions (1112) and the connecting portion (1114), and two second assembling portions (1112b) which are protruding shafts respectively disposed at the latching portions (1112) of the U-shaped body (1110), wherein the connecting portion (1114) is configured to be bent due to resilient force of the U-shaped body (1110), such that the latching portions (1112) are relatively away from each other to increase a diameter of the opening (1120); and
a fan (1200) placed into the U-shaped body (1110) through the opening (1120) and fixed to the holder (1100) by the latching portions due to the resilient force of the U-shaped body (1110),
the holder (1100) being disposed between the brackets (1300), wherein the first assembling portions (1310) of the brackets (1300) are assembled to the second assembling portions (1112b) of the U-shape body (1110) correspondingly, and the second assembling portions (1112b) of the U-shape body (1110) are respectively placed into the first assembling portions (1310) of the bracket (1300) from the edge of the bracket (1300) directly.

2. The fan module (1000) as claimed in claim 1, wherein the latching portions (1112) and the connecting portion (1114) are in a plate-like shape.

3. The fan module (1000) as claimed in claim 2, wherein the connecting portion (1114) are further formed a plurality of hollow portions (1116) for reducing a weight of the U-shaped body (1110).

4. The fan module (1000) as claimed in claim 1, wherein the latching portions (1112) of the U-shaped body (1110) have a plurality of first latching units (1112a), the fan (1200) has a plurality of second latching units (1210) corresponding to the first latching units (1112a), and when the fan (1200) is placed into the U-shaped body (1110) of the holder (1100), the first latching units (1112a) correspondingly latch the second latching units (1210).

5. The fan module (1000) as claimed in claim 4, wherein the first latching units (1112a) are protruding points or bumps, and the second latching units (1210) are recesses or openings.

## Patentansprüche

1. Lüftermodul (1000), **dadurch gekennzeichnet, dass** es umfasst:
zwei Halterungen (1300), wobei jede der Halterungen (1300) einen ersten Montageabschnitt (1310) umfasst, der ein Schlitz ist, der an einem Rand der Halterung (1300) gebildet ist;
einen Halter (1100), der einen U-förmigen Körper (1110) umfasst, mit zwei Arretierungsabschnitten (1112) und einem Verbindungsabschnitt (1114), der zwischen den Arretierungsabschnitten (1112) verbunden ist, und einer Öffnung (1120), die sich zwischen den Arretierungsabschnitten (1112) und dem Verbindungsabschnitt (1114) befindet, und zwei zweite Montageabschnitte (1112b), welche hervorstehende Stifte sind, die jeweils an den Arretierungsabschnitten (1112) des U-förmigen Körpers (1110) angeordnet sind, wobei der Verbindungsabschnitt (1114) konfiguriert ist, um aufgrund einer Federkraft des U-förmigen Körpers (1110) verbogen zu werden, so dass sich die Arretierungsabschnitte (1112) relativ weit voneinander entfernt befinden, um einen Durchmesser der Öffnung (1120) zu erhöhen; und
einen Lüfter (1200), der durch die Öffnung (1120) in dem U-förmigen Körper (1110) platziert ist und durch die Arretierungsabschnitte aufgrund der Federkraft des U-förmigen Körpers (1110) an dem Halter (1100) befestigt ist,
wobei der Halter (1100) zwischen den Halterungen (1300) angeordnet ist, wobei die ersten Montageabschnitt (1310) der Halterungen (1300) entsprechend mit den zweiten Montageabschnitten (1112b) des U-förmigen Körpers (1110) zusammengebaut sind und die zweiten Montageabschnitte (1112b) des U-förmigen Körpers (1110) jeweils von dem Rand der Halterung (1300) direkt in die ersten Montageabschnitte (1310) der Halterung (1300) platziert sind.

2. Lüftermodul (1000) gemäß Anspruch 1, wobei die Arretierungsabschnitte (1112) und die Verbindungsabschnitte (1114) eine plattenartige Form aufweisen.

3. Lüftermodul (1000) gemäß Anspruch 2, wobei der Verbindungsabschnitt (1114) weiterhin eine Vielzahl hohler Abschnitte (1116) bildet, um ein Gewicht des U-förmigen Körpers (1110) zu reduzieren.

4. Lüftermodul (1000) gemäß Anspruch 1, wobei die Arretierungsabschnitte (1112) des U-förmigen Körpers (1110) eine Vielzahl erster Arretierungseinheiten (1112a) aufweisen, der Lüfter (1200) eine Vielzahl zweiter Arretierungseinheiten (1210) aufweist, die den ersten Arretierungseinheiten (1112a) entsprechen, und die ersten Arretierungseinheiten (1112a) entsprechend mit den zweiten Arretierungseinheiten (1210) einrasten, wenn der Lüfter (1200) in dem U-förmigen Körper (1110) des Halters (1100) platziert wird.

5. Lüftermodul (1000) gemäß Anspruch 4, wobei die ersten Arretierungseinheiten (1112a) vorstehende Punkte oder Höcker sind und die zweiten Arretierungseinheiten (1210) Aussparungen oder Öffnungen sind.

## Revendications

1. Module de ventilateur (1000), **caractérisé en ce qu'**il comprend :
deux consoles (1300), chacune des consoles (1300) comprenant une première section d'assemblage (1310) qui est une fente pratiquée sur un bord de la console (1300) ;
un support (1100) comprenant un corps en forme de U (1110) doté de deux sections de verrouillage (1112) et d'une section de connexion (1114) connectées entre les sections de verrouillage (1112) et une ouverture (1120) située entre les sections de verrouillage (1112) et la section de connexion (1114), et deux secondes sections d'assemblage (1112b) qui sont des tiges proéminentes disposées respectivement au niveau des sections de verrouillage (1112) du corps en forme de U (1110), la section de connexion (1114) étant conçue pour être fléchie en raison de la force élastique du corps en forme de U (1110), de sorte que les sections de verrouillage (1112) sont relativement éloignées l'une de l'autre pour augmenter un diamètre de l'ouverture (1120) ; et
un ventilateur (1200) placé dans le corps en forme de U (1110) à travers l'ouverture (1120) et fixé au support (1100) par les sections de verrouillage en raison de la force élastique du corps en forme de U (1110),
le support (1100) étant disposé entre les consoles (1300), les premières sections d'assemblage (1310) des consoles (1300) étant assemblées d'une manière correspondante aux secondes sections d'assemblage (1112b) du corps en forme de U (1110) et les secondes sections d'assemblage (1112b) du corps en forme de U (1110) étant respectivement directement placées dans les premières sections d'assemblage (1310) de la console (1300) en partant du bord de la console (1300).

2. Module de ventilateur (1000) selon la revendication 1, dans lequel les sections de verrouillage (1112) et la section de connexion (1114) ont une forme de plaque.

3. Module de ventilateur (1000) selon la revendication 2, dans lequel la section de connexion (1114) est en outre formée d'une pluralité de sections creuses (1116) pour réduire un poids du corps en forme de U (1110).

4. Module de ventilateur (1000) selon la revendication 1, dans lequel les sections de verrouillage (1112) du corps en forme de U (1110) comportent une pluralité de premières unités de verrouillage (1112a), le ventilateur (1200) comporte une pluralité de secondes unités de verrouillage (1210) correspondant aux premières unités de verrouillage (1112a) et, lorsque le ventilateur (1200) est placé dans le corps en forme de U (1110) du support (1100), les premières unités de verrouillage (1112a) verrouillent de manière correspondante les secondes unités de verrouillage (1210) .

5. Module de ventilateur (1000) selon la revendication 4, dans lequel les premières unités de verrouillage (1112a) sont des points proéminents ou des sauts et les secondes unités de verrouillage (1210) sont des retraits ou des ouvertures.
